(19) Europäisches Patentamt
European Patent Office
Office européen des brevets

(11) Publication number: 0 384 707 B1

(12) # EUROPEAN PATENT SPECIFICATION

(45) Date of publication of patent specification: **18.10.95 Bulletin 95/42**

(51) Int. Cl.$^6$: **H01L 23/29**

(21) Application number: **90301808.3**

(22) Date of filing: **20.02.90**

(54) **Semiconductor device encapsulating epoxy resin composition.**

(30) Priority: **20.02.89 JP 41057/89**
**20.02.89 JP 41058/89**

(43) Date of publication of application: **29.08.90 Bulletin 90/35**

(45) Publication of the grant of the patent: **18.10.95 Bulletin 95/42**

(84) Designated Contracting States: **DE FR GB IT NL**

(56) References cited:
**EP-A- 0 230 145**
**EP-A- 0 285 450**
**EP-A- 0 418 888**
**PATENT ABSTRACTS OF JAPAN, vol. 13, no. 61 (C-567)(3409), 10 February 1989**
**CHEMICAL PATENTS INDEX, BASIC ABSTRACTS JOURNAL, Section Ch, Week 8719, 08 July 1987, Derwent Publications Ltd., London (GB); Class A, AN 87-133433/19**
**PATENT ABSTRACTS OF JAPAN, vol. 12, no. 353 (C-530)(3200), 21 September 1988**
**WPIL, Derwent Publications Ltd., London (GB); AN 90-309089**
**PATENT ABSTRACTS OF JAPAN, vol. 11, no. 307 (C-450)(2754), 07 October 1987**

(73) Proprietor: **TORAY INDUSTRIES, INC.**
**2-1, Nihonbashi-Muromachi 2-chome**
**Chuo-ku**
**Tokyo 103 (JP)**

(72) Inventor: **Kayaba, Keiji**
**G-1-3, Toray Shataku,**
**82, Ikegamidai 1-chome**
**Midori-ku, Nagoya-shi, Aichi (JP)**
Inventor: **Sawamura, Yasushi**
**Toray Mizuho-ryo,**
**33-1 Hasshodouri 2-chome**
**Mizuho-ku Nagoya-shi , Aichi (JP)**
Inventor: **Tanaka, Masayuki**
**258 Horagai 1-chome,**
**Midori-ku**
**Nagoya-shi, Aichi (JP)**

(74) Representative: **Coleiro, Raymond et al**
**MEWBURN ELLIS**
**York House**
**23 Kingsway**
**London WC2B 6HP (GB)**

EP 0 384 707 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a semiconductor-encapsulating epoxy resin composition having excellent moldability and reliability and a good solder dipping stability.

Epoxy resins have an excellent heat resistance, moisture resistance, and electrical characteristics, and various characteristics can be obtained by modifying the recipes thereof. Accordingly, therefore, epoxy resins are used as for paints, adhesives, and industrial materials such as electrically insulating materials.

As methods of encapsulating electronic circuit parts such as semiconductor devices, a hermetic encapsulating method using metals or ceramics, and a resin encapsulating method using a phenolic resin, a silicone resin, an epoxy resin or the like have been proposed, but from the economical viewpoint, the productivity and the balance among physical properties, the resin encapsulating method using an epoxy resin is mainly adopted.

According to the encapsulating method using an epoxy resin, a composition formed by adding a curing agent, a filler and the like is used, and a semiconductor element is set in a mold and is usually encapsulated by the transfer molding method or the like.

The main characteristics required for the encapsulating epoxy resin composition are reliability and moldability. The moisture resistance is covered by the term reliability, and the flowability, hot hardness and flash-preventing property are covered by the term moldability.

When a resin-encapsulated semiconductor is allowed to stand in a high-temperature and high-humidity environment, water seeps through the encapsulating resin or the interface between the encapsulating resin and a lead frame to cause defects in the semiconductor. Accordingly, the term moisture resistance as used herein refers to the property of preventing or minimizing the above-mentioned imperfections of the semiconductor caused by water. Note that recent increases in the degree of integration of semiconductors has led to a demand for a higher moisture resistance.

Usually, a silane coupling agent is added, to improve the moisture resistance of an encapsulating resin. More specifically the addition of an epoxysilane (JP-B-62-18565), the addition of a mercaptosilane (JP-A-55-153357), and the addition of an aminosiliane having a primary amino group (JP-A-57-155753) have been proposed.

EP-A-0285450 discloses an epoxy resin composition containing silica powder whose surface is treated with a silane coupling agent, silicone-base surface active agent and a thermosetting silicon rubber.

The addition of a silane coupling agent to a sealing resin effectively improve the moisture resistance, but it has been found that a higher moisture resistance is required for a semiconductor having a high degree of integration and the moisture resistance provided by the conventional silane coupling agents is still too low.

In the conventional method of adding an aminosilane having a primary amino group, the moisture resistance is improved, and simultaneously, moldability-improving effects such as an improvement of the hot hardness and reduction of the formation of flash are obtained. Nevertheless, this method cannot be practically adopted because the flowability is reduced.

In the field of semiconductor integrated circuits, techniques of increasing the integration degree and reliability recently have been developed, and the automation of the step of assembling semiconductor devices has been advanced.

To attach a semiconductor device of the flat package type to a circuit board, a method has been adopted in which soldering of every lead pin is carried out, but currently a surface mounting method is employed in which a semiconductor device is entirely dipped in a solder bath heated to a temperature higher than 250°C to effect soldering. Accordingly, in a conventional package encapsulated by an encapsulating resin, cracking of the resin portion occurs at the soldering step, whereby the reliability is lost, and accordingly, the obtained product cannot be practically used.

Various methods of improving the solder cracking resistance of encapsulating resins have been examined. For example, a method of using a biphenyl type epoxy resin has been proposed JP-A-63-251419). This method of using a biphenyl type epoxy resin improves the solder cracking resistance of the encapsulating resin, but the moisture resistance is lowered, the hot hardness at the molding is, low and the formation of flash is heightened.

Therefore, primarily, the present invention seeks to solve the above-mentioned problems of conventional semiconductor-encapsulating epoxy resin compositions, and to provide an epoxy resin composition having an excellent reliability such as a high moisture resistance, and moldability such as a hot hardness and a flash-prevention property, and having a good solder dipping stability, to thereby obtain a resin-encapsulated semiconductor to which the surface mounting method can be applied.

In accordance with the present invention, there is provided a semiconductor-encapsulating epoxy resin composition comprising (A) an epoxy resin comprising a biphenyl type epoxy resin having a skeleton component represented by the following formula (I)

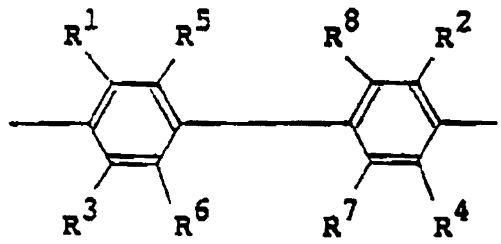

(I)

wherein $R^1$ to $R^8$ are each, independently of one another, a hydrogen atom, a lower alkyl group having 1 to 4 carbon atoms or a halogen atom,
(B) a curing agent, (C) a filler and (D) a silane coupling agent having at least one amino group, the or each amino group being a secondary amino group.

Preferred embodiments of the invention will now be described.

An epoxy resin having at least two epoxy groups in the molecule can be used as a component of the epoxy resin (A) in the present invention, without any particular limitation. As examples of the epoxy resin (A), there can be mentioned a cresol-novolak epoxy resin, a biphenyl type epoxy resin, a bisphenol A type epoxy resin, a linear aliphatic epoxy resin, an alicyclic epoxy resin, a heterocyclic epoxy resin, a halogenated epoxy resin and a spiro ring-containing epoxy resin. At least two of these epoxy resins can be used in combination in some applications.

However, from the viewpoint of the solder dipping stability of the composition, a biphenyl type epoxy resin having a skeleton represented by the following formula (I) is present as an indispensable component of the epoxy resin (A):

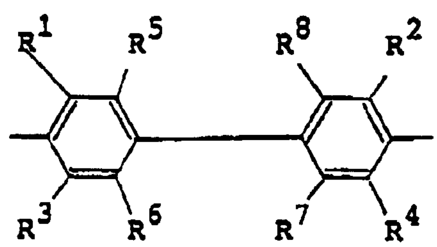

(I)

wherein $R^1$ to $R^8$ are each, independently of one another, a hydrogen atom, a lower alkyl group having 1 to 4 carbon atoms or a halogen atom.

Preferred examples of $R^1$ to $R^8$ in the above-mentioned formula (I), are a hydrogen atom, a methyl group, an ethyl group, a n-propyl group, an i-propyl group, a n-butyl group, a sec.-butyl group, a tert.-butyl group, a chlorine atom, and a bromine atom.

Specific examples of the biphenyl type epoxy resin having a skeleton represented by the above-mentioned formula (I) are 4,4′-bis(2,3-epoxypropoxy)biphenyl, 4,4′-bis(2,3-epoxypropoxy)-3,3′,5,5′-tetramethylbiphenyl, 4,4′-bis(2,3-epoxypropoxy)-3,3′,5,5′-tetramethyl-2-chlorobiphenyl, 4,4′-bis(2,3-epoxypropoxy)-3,3′,5,5′-tetramethyl-2-bromobiphenyl, 4,4′-bis(2,3-epoxypropoxy)-3,3′,5,5′-tetraethylbiphenyl, and 4,4′-(2,3-epoxypropoxy)-3,3′,5,5′-tetrabutylbiphenyl.

In the present invention, the amount of the epoxy resin (A) incorporated is preferably 3 to 30% by weight, more preferably 5 to 25% by weight based on the total weight of the resin composition.

Any curing agent capable of reacting with and curing the epoxy resin (A) can be used as the curing agent (B) in the present invention. Examples are phenol-novolak resin, a cresol-novolak resin, a novolak resin represented by the following formula (II):

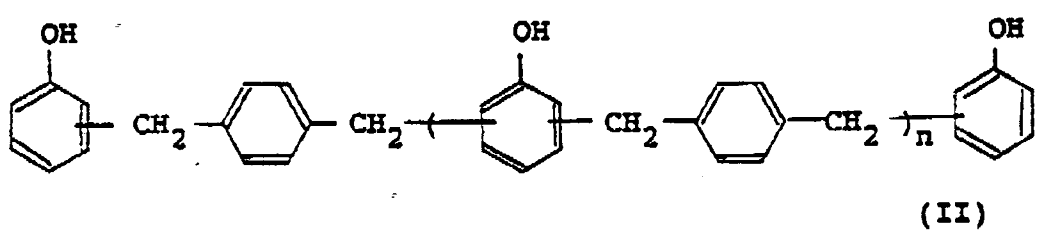

(II)

wherein n is 0 or an integer of at least 1, novolak resins synthesized from bisphenol A or resorcinol, various polyhydric phenol compounds, acid anhydrides such as maleic anhydride, phthalic anhydride and pyromellitic anhydride, and aromatic amines such as methaphenylenediamine, diaminodiphenylmethane, and diaminodiphenylsulfone.

In view of the heat resistance, moisture resistance and storage stability of a semiconductor device-sealing epoxy resin, a curing agent composed of a novolak resin such as a phenol-novolak resin or a cresol-novolak resin is preferably used. A mixture of two or more of these curing agents can be used according to need.

In the present invention, the amount of the curing agent (B) incorporated is preferably 1 to 20% by weight more preferably 2 to 15% by weight based on the total weight of the resin composition.

In view of the mechanical properties and moisture resistance, preferably the mixing ratio of the epoxy resin (A) and the curing agent (B) is such that the chemical equivalent ratio of the component (B) to the component (A) is from 0.5 to 1.6, more preferably from 0.8 to 1.3.

As the filler (C) used in the present invention, examples are fused silica, crystalline silica, antimony trioxide, calcium carbonate, magnesium carbonate, alumina, magnesia, clay, talc, calcium silicate, titanium oxide, asbestos, and glass fiber. Among these, fused silica is preferably used because the effect thereof of reducing the linear expansion coefficient is high and the stress is effectively reduced. From the viewpoint of the solder dipping stability, preferably the mixing ratio of the filler (C) is 73 to 90% by weight based on the entire composition, and the filler (C) comprises fused silica comprising (C′) 90 to 40% by weight of crushed fused silica having an average particle diameter not larger than 12 μm and (C″) 10 to 60% by weight of spherical fused silica having an average particle diameter not larger than 40 μm.

The average particle diameter referred to herein means the particle diameter (median diameter) at which the cumulative weight is 50%.

In the present invention, a silane compound having a secondary amino group and in which the only amino group, or all of the amino groups, are secondary amino groups, must be used as the silane coupling agent (D). The silane coupling agent having a secondary amino group enables the moldability and reliability can be synergistically improved, as compared with the case in which a conventional coupling agent having a primary amino group is used, and the flowability of the composition is especially remarkably improved, and thus a thin package in which the formation of flash is reduced can be molded.

Specific examples of the silane coupling agent (D), are compounds represented by the following formulae (III) and (IV):

$$R^9NHR^{12}\underset{(R^{11})_{3-n}}{\underset{|}{Si}}(OR^{10})_n \qquad (III)$$

and

$$R^9NHR^{13}NHR^{12}\underset{(R^{11})_{3-n}}{\underset{|}{Si}}(OR^{10})_n \qquad (IV)$$

wherein $R^9$ to $R^{11}$ independently represent a monovalent hydrocarbon group having 1 to 20 carbon atoms, $R^{12}$ and $R^{13}$ independently represent a divalent hydrocarbon group having 1 to 20 carbon atoms, and n is an integer of 1 to 3.

Among these silane coupling agents, a compound of the formula (III) in which $R^9$ represents a phenyl group, $R^{10}$ and $R^{11}$ represent a methyl group and/or an ethyl group, $R^{12}$ represents a propylene group and n is 2 or 3 is preferably used as the silane coupling agent (D), because the effects of improving the moldability and reliability are high.

In view of the moldability and reliability, preferably the silane coupling agent (D) is incorporated in an amount of 0.1 to 5 parts by weight, more preferably 0.2 to 3 parts by weight, most preferably 0.3 to 1.5 parts by weight, per 100 parts by weight of the filler. A silane coupling agent such as an epoxysilane or mercaptosilane can be used in combination with the silane coupling agent (D) according to need.

From the viewpoint of the reliability, preferably the filler (C) is first surface-treated with the silane coupling agent (D) or other silane coupling agent such as an epoxysilane or mercaptosilane.

To improve the solder dipping stability, an aromatic vinyl hydrocarbon-conjugated diene block copolymer (E) can be further added to the composition of the present invention. The aromatic vinyl hydrocarbon-conjugated diene block copolymer (E) includes a linear, parabolic or branched block copolymer comprising blocks of an aromatic vinyl hydrocarbon polymer having a glass transition temperature of at least 25°C, preferably at least 50°C, and blocks of a conjugated diene polymer having a glass transition temperature not higher than 0°C, preferably not higher than -25°C.

As the aromatic vinyl hydrocarbon, there can be mentioned styrene, α-methylstyrene, o-methylstyrene, p-methylstyrene, 1,3-dimethylstyrene, and vinylnaphthalene, and of these compounds, styrene is preferably used.

As the conjugated diene, there can be mentioned butadiene (1,3-butadiene), isoprene (2-methyl-1,3-butadiene), methylisoprene (2,3-dimethyl-1,3-butadiene) and 1,3-pentadiene, and of these conjugated dienes, butadiene and isoprene are preferably used.

The proportion of the blocks of the aromatic vinyl hydrocarbon, which are blocks of the glass phase, in the block copolymer (E) is preferably 10 to 50% by weight, and the proportion of the blocks of the conjugated diene polymer, which are blocks of the rubber phase, is preferably 90 to 50% by weight.

Many combinations of the blocks of the glass phase and the blocks of the rubber phase are possible and any of these combinations can be adopted, but a triblock copolymer comprising blocks of the glass phase bonded to both ends of the intermediate block of the rubber phase is preferably used.

In this case, the number average molecular weight of the block of the glass phase is preferably 5,000 to 150,000, more preferably 7,000 to 60,000, and the number average molecular weight of the block of the rubber phase is preferably 10,000 to 300,000, more preferably 30,000 to 150,000.

The aromatic vinyl hydrocarbon-conjugated diene block copolymer (E) can be prepared by the known living anionic polymerization process, but the preparation thereof is not limited to this polymerization process. Namely, the aromatic vinyl hydrocarbon-conjugated diene block copolymer (E) also can be prepared by the cationic polymerization process and the radical polymerization process.

The aromatic vinyl hydrocarbon-conjugated diene block copolymer (E) also includes a hydrogenated block copolymer formed by reducing parts of unsaturated bonds of the above-mentioned block copolymer by hydrogenation. In this case, preferably not more than 25% of aromatic double bonds of the blocks of the aromatic vinyl hydrocarbon polymer is hydrogenated, and at least 80% of aliphatic double bonds of the blocks of the conjugated diene polymer is hydrogenated.

Preferred examples of the aromatic vinyl hydrocarbon-conjugated diene block copolymer (E) are a polystyrene/polybutadiene/polystyrene block copolymer (SBS), a polystyrene/polyisoprene/polystyrene triblock copolymer (SIS), a hydrogenated copolymer of SBS (SEBS), and a hydrogenated copolymer of SIS. Of these, a hydrogenated copolymer of SBS (SEBS) and a hydrogenated copolymer of SIS are more preferable in view of the heat resistance.

The amount of the aromatic vinyl hydrocarbon-conjugated diene block copolymer (E) incorporated is preferably 0.2 to 5% by weight, more preferably 1 to 4% by weight based on the total weight of the resin composition.

To reduce the stress and to improve the reliability, a modified silicone oil (F) can be further added to the composition of the present invention.

The modified silicone oil (F) used in the present invention has an organopolysiloxane structure. As specific examples, there can be mentioned compounds represented by the following formula (V):

$$Y \!-\!\!\left( \begin{array}{c} R^{14} \\ | \\ SiO \\ | \\ R^{15} \end{array} \right)_{\!n} \!\!-\!\! \left( \begin{array}{c} R^{16} \\ | \\ SiO \\ | \\ X \end{array} \right)_{\!m} \!\!-\! \begin{array}{c} R^{17} \\ | \\ Si \\ | \\ R^{18} \end{array} \!-\! Y \qquad (V)$$

wherein $R^{14}$ to $R^{18}$ independently represent a hydrogen atom at least one functional group selected from the group consisting of an alkyl group having 1 to 20 carbon atoms, a phenyl group and a vinyl group, X and Y represent at least one functional group selected from the group consisting of an alkyl group having 1 to 20 carbon atoms, a phenyl group, a vinyl group, a hydroxyl group, an amino group, an epoxy group, a carboxyl group, a mercapto group, a polyoxyalkylene group, an alkoxy group and a fluorine atom, with the proviso that Y can be a hydrogen atom, and m is an integer of at least 1 and n is 0 or an integer of at least 1.

To reduce the stress and improve the reliability, preferably the modified silicone oil (F) is incorporated in an amount of 0.01 to 5% by weight, more preferably 0.1 to 3% by weight, most preferably 0.3 to 2% by weight.

In the present invention, a curing catalyst can be used for promoting the curing reaction between the epoxy resin (A) and the curing agent (B), and any compound capable of promoting the curing reaction can be used in the present invention without limitation. For example, there can be used imidazole compounds such as 2-methylimidazole, 2-4-dimethylimidazole, 2-ethyl-4-methylimidazole, 2-phenylimidazole, 2-phenyl-4-methylimidazole and 2-heptadecylimidazole, tertiary amine compounds such as triethylamine, benzyldimethylamine, α-methylbenzyldimethylamine, 2-(dimethylaminomethyl)phenol, 2,4,6-tris(dimethylaminomethyl)phenol and 1,8-diazabicyclo(5,4,0)undecene-7, organic metal compounds such as zirconium tetramethoxide, zirconium tetrapropoxide, tetrakis(acetylacetonate)zirconium and tri(acetylacetonate)aluminum, and organic phosphine compounds (G) such as triphenylphosphine, trimethylphosphine, triethylphosphine, tributylphosphine, tri(p-methylphenyl)phosphine and tri(nonylphenyl)phosphine. From the viewpoint of the moisture resistance, an organic phosphine compound (G) is preferably used, and triphenylphosphine is more preferably used.

A mixture of two or more of these curing catalysts can be used according to need. Preferably, the curing catalyst is incorporated in an amount of 0.1 to 10 parts by weight per 100 parts by weight of the epoxy resin (A).

A halogen compound such as a halogenated epoxy resin, a flame retardant such as phosphorus compounds, a flame retardant assistant such as antimony trioxide, a colorant such as carbon black or iron oxide, an elastomer other than the above-mentioned aromatic vinyl hydrocarbon-conjugated diene block copolymer (E), such as a silicone rubber, an olefin copolymer, a modified nitrile rubber or a modified polybutadiene rubber, a thermoplastic resin such as polyethylene, a coupling agent such as a titanate coupling agent, a release agent such as a long-chain fatty acid, a metal salt of a long-chain fatty acid, an ester of a long-chain fatty acid, an amide of a long-chain fatty acid or a paraffin wax, and a crosslinking agent such as an organic peroxide can be incorporated into the epoxy resin composition of the present invention.

The epoxy resin composition is preferably melt-kneaded. For example, the epoxy resin composition can be prepared by carrying out the melt-kneading according to a known kneading method using a Banbury mixer, a kneader, a roll, a single-screw or twin-screw extruder or a cokneader.

The present invention will now be described in detail with reference to the following examples.

Example 1

Using fused silica (I) shown in Table 2 and a silane coupling agent shown in Table 3, dry blending was carried out at the mixing ratios shown in Table 1 and 6 by using a mixer. The blend was heated and kneaded for 5 minutes by using a mixing roll having a surface temperature maintained at 90°C, and then cooled and pulverized to prepare an epoxy resin composition.

The moldability characteristics such as the spiral flow, formation of resin flash and hot hardness of the formed composition were evaluated by the low-pressure transfer molding method. A test element was encapsulated with the thermosetting resin and post curing carried out, and the reliability of the device was evaluated. The results are shown in Table 6.

In this example, the properties were evaluated according to the following methods.

(Spiral Flow, Formation of Resin Flash and Hot Hardness)

Molding was carried out at 175°C for 120 seconds and the respective properties were evaluated.

(Reliability)

A 44-Pin QFP having encapsulated test elements was molded, and post curing was carried out at 175°C for 5 hours. The QFP was subjected to the unsaturated pressure cooker bias test (USPCBT) at a temperature of 130°C and a relative humidity of 85% under a bias voltage of 15 V, and the time required for the cumulative failure rate to reach 50% was measured.

As seen from the results shown in Table 6, the epoxy resin composition of the present invention (runs 1 to 3) has excellent moldability characteristics such as spiral flow, formation of resin flash and hot hardness, and a high reliability. In runs 1 and 2, in which the organic phosphine compound (G) is incorporated, the reliability is especially excellent.

In contrast, if the secondary amino group-containing silane coupling agent (D) of the present invention is not incorporated (comparative runs 1 to 3) the moldability and reliability are poor.

Table 1

| Component | Content | Amount added (% by weight) |
| --- | --- | --- |
| Epoxy resin A | o-Cresol-novolak type epoxy resin having epoxy equivalent of 190 | * |
| Curing agent B | Phenol-novolak resin having hydroxyl equivalent of 110 | * |
| Curing catalyst | Triphenylphosphine (TPP) or 1,8-diaza-bicyclo(5,4,0)undecene-7 (DBU) | 0.2 |
| Release agent | Stearic acid | 0.3 |
| Flame retardant | Brominated phenol-novolak resin having epoxy equivalent of 270 and bromine content of 36% | 2.3 |
| Flame retardant assistant | Antimony trioxide | 1.5 ** |
| Colorant | Carbon black | 0.2 |

**Note**

*: The curing agent was added in an amount which is a molar equivalent to the epoxy resin and flame retardant.

**: Also serves as a filler component.

Table 2

Fused silica

| Fused silica | Crushed fused silica having average particle diameter of 13.4 μm (% by weight) | Crushed fused silica (C') having average particle diameter of 9.6 μm (% by weight) | Spherical fused silica (C") having average particle diameter of 23.8 μm (% by weight) |
|---|---|---|---|
| I | 70 | 0 | 30 |
| II | 0 | 90 | 10 |
| III | 0 | 70 | 30 |
| IV | 0 | 40 | 60 |
| V | 0 | 30 | 70 |

Table 3

Silane coupling agent

| | Structure |
|---|---|
| I | 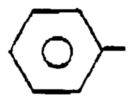 $-NHCH_2CH_2CH_2Si(OCH_3)_3$ |
| II | $H_2NCH_2CH_2NHCH_2CH_2CH_2Si(OCH_3)_3$ |
| III | 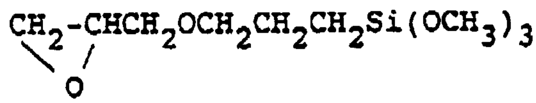 |

Table 6

Results of Example 1

| | Composition | | | | | | Evaluation results | | | |
|---|---|---|---|---|---|---|---|---|---|---|
| | Curing promoter | Silane coupling agent | | Fused silica | | Filler (C) | Moldability characteristics | | | Reliability |
| | Kind | Kind | Amount added (% by weight) | Kind | Amount added (% by weight) | Amount added (% by weight) | Spiral flow (cm) | Resin flash (mm) | Hot hardness (Shore D) | (hours) |
| Run 1 | TPP | I | 0.5 | I | 74.0 | 75.5 | 72 | 1.0 | 86 | 530 |
| Run 2 | TPP | I | 1.0 | I | 74.0 | 75.5 | 76 | 1.5 | 88 | 510 |
| Run 3 | DBU | I | 0.5 | I | 74.0 | 75.5 | 70 | 1.0 | 85 | 400 |
| Comparative run 1 | TPP | II | 0.5 | I | 74.0 | 75.5 | 55 | 3.0 | 83 | 290 |
| Comparative run 2 | TPP | III | 0.5 | I | 74.0 | 75.5 | 63 | 6.0 | 81 | 270 |
| Comparative run 3 | TPP | - | - | I | 74.0 | 75.5 | 60 | 7.0 | 79 | 60 |

Example 2

Using fused silica shown in Table 2 and a silane coupling agent (I) shown in Table 3, dry blending was carried out at the mixing ratios shown in Tables 1 and 7 by using a mixer. The blend was heated and kneaded for 5 minutes by using a mixing roll having a surface temperature maintained at 90°C, and then cooled and pulverized to prepare an epoxy resin composition.

The moldability characteristics such as formation of resin flash and hot hardness of the obtained composition were evaluated. Furthermore, a device having test elements was molded, encapsulated, and post-cured, and the reliability and solder dipping stability were evaluated.

The solder dipping stability was evaluated by post-curing a 44-pin QFP having encapsulated test elements for 5 hours, humidifying the QFP at a temperature of 65°C and a relative humidity of 95% for 24 hours, dipping the QFP in a solder bath maintained at 245°C for 5 seconds, and determining the ratio (%) of QFP at which cracking did not occur.

The results are shown in Table 7.

As seen from the results shown in Table 7, the epoxy resin composition containing 75 to 90% by weight of the filler (C) comprising the specific fused silica according to the present invention (runs 4 and 6 to 8) has an excellent moldability, reliability, and solder dipping stability.

Table 7

Results of Example 2

| | Composition | | | | | | Results of Evaluation | | | |
|---|---|---|---|---|---|---|---|---|---|---|
| | Curing promoter | Silane coupling agent | | Fused silica | | Filler (C) | Moldability characteristics | | Reliability | Solder dipping stability (%) |
| | Kind | Kind | Amount added (% by weight) | Kind | Amount added (% by weight) | Amount added (% by weight) | Resin flash (mm) | Hot hardness (Shore D) | (hours) | |
| Run 1 | TPP | I | 0.5 | I | 74.0 | 75.5 | 1.0 | 86 | 530 | 15 |
| Run 4 | TPP | I | 0.5 | II | 74.0 | 75.5 | 1.0 | 86 | 590 | 80 |
| Run 5 | TPP | I | 1.0 | III | 71.0 | 72.5 | 1.0 | 85 | 570 | 10 |
| Run 6 | TPP | I | 0.5 | III | 74.0 | 75.5 | 2.0 | 87 | 540 | 70 |
| Run 7 | TPP | I | 0.5 | IV | 74.0 | 75.5 | 1.0 | 86 | 560 | 65 |
| Run 8 | TPP | I | 0.5 | IV | 76.0 | 77.5 | 2.0 | 88 | 600 | 70 |
| Run 9 | TPP | I | 0.5 | V | 74.0 | 75.5 | 1.5 | 85 | 570 | 20 |

Example 3

Using fused silica (I) shown in Table 2, a silane coupling agent (I) shown in Table 3, and a modified silicone oil (F) shown in Table 4, dry blending was carried out at the mixing ratios shown in Tables 1 and 8 by using a mixer. The blend was heated and kneaded for 5 minutes by using a mixing roll having a surface temperature maintained at 90°C, and then cooled and pulverized to prepare an epoxy resin composition.

The formation of resin flash and hot hardness of the obtained resin composition were evaluated by the low-pressure transfer molding method, a flexural test piece was molded and post-cured and the flexural modulus of elasticity thereof was measured according to ASTM D-790, and further, a device having encapsulated test elements was molded and post-cured and the reliability thereof was evaluated. The results are shown in Table 8.

From the results shown in Table 8, it is seen that the epoxy resin composition comprising the modified silicone oil (F) according to the present invention (Run No. 10 to No. 13) has an excellent moldability, and a reliability further improved. Moreover, the flexural modulus of elasticity is reduced and a reduction of stress is obtained.

Table 4

Modified silicone oil

| Modified silicone oil (F) | Content |
|---|---|
| I | Carboxylic acid-modified silicone oil, SF8418 supplied by Toray Silicone |
| II | Epoxy-modified silicone oil, X-60-164 supplied by Shinetsu Silicone |
| III | Silicone oil having both terminals modified with amino groups, X-22-161A supplied by Shinetsu Silicone |
| IV | Silicone oil having both terminals modified with carboxylic acid, BY15-750 supplied by Toray Silicone |

Table 8

Results of Example 3

| | Composition | | | | | | | | Evaluation characteristics | | | |
|---|---|---|---|---|---|---|---|---|---|---|---|---|
| | Curing promoter | Silane coupling agent | | Fused silica | | Filler (C) | Modified silicone oil (F) | | Moldability characteristics | | Flexural modulus of elasticity | Reliability |
| | Kind | Kind | Amount added (% by weight) | Kind | Amount added (% by weight) | Amount added (% by weight) | Kind | Amount added (% by weight) | Resin flash (mm) | Hot hardness (Shore D) | ($kg/mm^2$) | (hours) |
| Run 1 | TPP | I | 0.5 | I | 74.0 | 75.5 | - | - | 1.0 | 86 | 1820 | 530 |
| Run 10 | TPP | I | 0.5 | I | 74.0 | 75.5 | I | 1.0 | 1.0 | 86 | 1610 | 670 |
| Run 11 | TPP | I | 0.5 | I | 74.0 | 75.5 | II | 1.5 | 1.0 | 84 | 1490 | 680 |
| Run 12 | TPP | I | 0.5 | I | 74.0 | 75.5 | III | 2.0 | 1.0 | 83 | 1370 | 630 |
| Run 13 | TPP | I | 0.5 | I | 74.0 | 75.5 | IV | 1.0 | 2.0 | 84 | 1560 | 600 |

Example 4

Using fused silica shown in Table 2 and a silane coupling agent shown in Table 3, dry blending was carried out at the mixing ratios shown in Tables 5 and 9, and the blend was treated in the same manner as described in Example 1 to obtain an epoxy resin composition, and the moldability, reliability and solder dipping stability thereof were evaluated. The results are shown in Table 9.

In the present example, the physical properties were evaluated according to the following methods.

(Formation of Resin Flash)

Molding was carried out at 175°C for 90 seconds and the formation of resin flash was observed.

(Hot Hardness)

Molding was carried out at 175°C for 120 seconds, and the hot hardness was evaluated.

(Reliability)

A 16-Pin DIP having encapsulated test elements was molded and post-cured at 175°C for 5 hours. This device was subjected to USPCBT (unsaturated pressure cooker bias test) at a temperature of 135°C and a relative humidity of 85% under a bias voltage of 15 V, and the time required for the cumulative failure rate to reach 50% was measured.

(Solder Dipping Stability)

A 44-Pin QFP having encapsulated elements was post-cured at 175°C for 5 hours, humidified at a temperature of 85°C and a relative humidity of 85% for 50 hours and dipped in a solder bath maintained at 260°C for 10 seconds, and the ratio (%) of QFP at which cracking did not occur was determined.

The results are shown in Table 9.

As seen from the results shown in Table 9, the epoxy resin composition of the present invention (runs 14 to 17) has excellent moldability characteristics such as a formation of resin flash and hot hardness, and reliability. If the epoxy resin I (biphenyl type epoxy resin) is incorporated, even under such severe conditions as a 10 second dip in a solder bath maintained at 260°C after 50 hours' humidification at a temperature of 85°C and a relative humidity of 85%, the solder dipping stability is 40% or higher and is very good.

In contrast, where the secondary amino group-containing silane coupling agent (D) of the present invention is not incorporated (comparative run 4), the moldability and reliability are poor.

Table 5

Epoxy resin composition

| Component | Content | Amount added (% by weight) |
|---|---|---|
| Epoxy resin I | 4,4'-Bis(2,3-epoxypropoxy)-3,3',5,5'-tetramethylbiphenyl | * |
| Epoxy resin II | o-Cresol-novolak epoxy resin having epoxy equivalent of 200 | * |
| Curing agent | Phenol-novolak resin having hydroxyl equivalent of 107 | the remainder |
| Curing promoter | Triphenylphosphine | 0.2 |
| Release agent | Carnauba wax | 0.3 |
| Flame retardant | Brominated phenol-novolak resin having epoxy equivalent 270 and bromine content of 36% | 2.3 |
| Flame retardant assistant | Antimony trioxide | 1.5 |
| Colorant | Carbon black | 0.2 |

Note

*: shown in Table 9.

Table 9

Results of Example 4

| | Composition | | | | | | | Evaluation results | | | |
|---|---|---|---|---|---|---|---|---|---|---|---|
| | Epoxy resin | | Silane coupling agent (D) | | Fused silica | | Filler (C) | Molding characteristics | | Reliability (hours) | Solder dipping stability (%) |
| | I | II | | | | | | | | | |
| | Amount added (% by weight) | Amount added (% by weight) | Kind | Amount added (% by weight) | Kind | Amount added (% by weight) | Amount added (% by weight) | Resin flash (mm) | Hot hardness (Shore D) | | |
| Run 14 | 10.0 | - | I | 0.5 | I | 78.0 | 79.5 | 1.0 | 84 | 400 | 45 |
| Run 15 | 10.0 | - | I | 1.0 | I | 78.0 | 79.5 | 1.0 | 86 | 450 | 40 |
| Run 16 | 5.0 | 5.0 | I | 0.5 | I | 78.0 | 79.5 | 1.0 | 85 | 450 | 40 |
| Run 17 | 10.0 | - | I | 0.5 | II | 78.0 | 79.5 | 1.0 | 81 | 420 | 85 |
| Comparative run 4 | 10.0 | - | III | 0.5 | II | 78.0 | 79.5 | 5.0 | 55 | 200 | 40 |

Example 5

Using fused silica (I) shown in Table 2, a silane coupling agent shown in Table 3 and an aromatic vinyl hydrocarbon-conjugated diene block copolymer [polystyrene/polybutadiene/polystyrene hydrogenated triblock copolymer (styrene/butadiene weight ratio = 25/75; number average molecular weight = $1.2 \times 10^5$)] (E) were blended at the mixing ratios shown in Tables 1 and 10, and in the same manner as described in Example 1, an epoxy resin composition was prepared and the moldability, reliability and solder dipping stability were evaluated.

The evaluation conditions and evaluation results are shown in Table 10.

In the present example, the physical properties were determined according to the following methods.

(Reliability)

An 80-Pin QFP having encapsulated test elements was molded and post-cured at 175°C for 5 hours. This QFP was subjected to USPCBT (unsaturated pressure cooker test) at a temperature of 130°C and a relative humidity of 85% under a bias voltage of 10V, and the time required for the cumulative failure rate to reach 50% was measured.

(Solder Dipping Stability)

An 80-Pin QFP having encapsulated test elements was molded and post-cured at 175°C for 5 hours, humidified at a temperature of 85°C and a relative humidity of 85% for 50 hours and dipped in a solder bath maintained at 250°C for 10 seconds, and the ratio (%) of QFP at which cracking did not occur was evaluated.

The results are shown in Table 10.

As seen from the results shown in Table 10, the epoxy resin composition of the present invention (runs 18 and 19) has a high hot hardness and excellent moldability and reliability, and if the aromatic vinyl hydrocarbon-conjugated diene block copolymer (E) is incorporated, the solder dipping stability is improved.

In contrast, where the secondary amino group-containing silane coupling agent (D) of the present invention is not incorporated (comparative run 5), the reliability is only 430 hours even under relatively mild conditions of a temperature of 130°C, a relative humidity of 85% and a bias voltage of 10 V, and the reliability is poor.

Table 10

Results of Example 5

| | Composition | | | | | | | Evaluation results | | |
|---|---|---|---|---|---|---|---|---|---|---|
| | Curing promoter | Styrenic block copolymer (E) | Silane coupling agent | | Fused silica | | Filler (G) | Moldability characteristics | Relia-bility (hours) | Solder dipping stability (%) |
| | Kind | Amount added (% by weight) | Kind | Amount added (% by weight) | Kind | Amount added (% by weight) | Amount added (% by weight) | Hot hardness (Shore D) | | |
| Run 18 | TPP | 2.5 | I | 0.5 | I | 72.5 | 74.0 | 86 | 750 | 60 |
| Run 19 | TPP | 2.5 | I | 1.0 | I | 72.5 | 74.0 | 85 | 720 | 60 |
| Comparative run 5 | TPP | 2.5 | II | 0.5 | I | 72.5 | 74.0 | 84 | 430 | 55 |

## Claims

1. A semiconductor-encapsulating epoxy resin composition comprising (A) an epoxy resin comprising a biphenyl type epoxy resin having a skeleton component represented by the following formula (I).

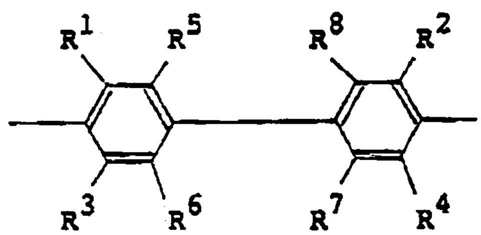

(I)

wherein $R^1$ to $R^8$ are each, independently of one another, a hydrogen atom, a lower alkyl group having 1 to 4 carbon atoms or a halogen atom,
(B) a curing agent, (C) a filler and (D) a silane coupling agent having at least one amino group, the or each amino group being a secondary amino group.

2. A semiconductor-encapsulating epoxy resin composition according to claim 1, wherein the curing agent (B) is a phenol-novolak resin.

3. A semiconductor-encapsulating epoxy resin composition according to claim 1 or 2, wherein the filler (C) comprises fused silica and the amount of the filler (C) is 73 to 90% by weight based on the total composition.

4. A semiconductor-encapsulating epoxy resin composition according to claim 3, wherein the fused silica comprises 40 to 90% by weight of (C′) crushed fused silica having an average particle diameter not larger than 12 μm and 10 to 60% by weight of (C″) spherical fused silica having an average particle diameter not larger than 40 μm.

5. A semiconductor-encapsulating epoxy resin composition according to any preceding claim, wherein the secondary amino group-containing silane coupling agent (D) is N-phenyl-3-aminopropyltrimethoxysilane.

6. A semiconductor-encapsulating epoxy resin composition according to any preceding claim, which further comprises (E) an aromatic vinyl hydrocarbon-conjugated diene block copolymer.

7. A semiconductor-encapsulating epoxy resin composition according to any preceding claim, which further comprises (F) a modified silicone oil.

8. A semiconductor-encapsulating epoxy resin composition according to any preceding claim, which further comprises (G) an organic phosphine compound.

## Patentansprüche

1. Halbleiter verkapselnde Epoxyharzzusammensetzung, welche umfaßt: (A) ein Epoxyharz, das ein Epoxyharz vom Biphenyltyp mit einer Grundgerüstkomponente umfaßt, die durch folgende Formel (I) dargestellt wird

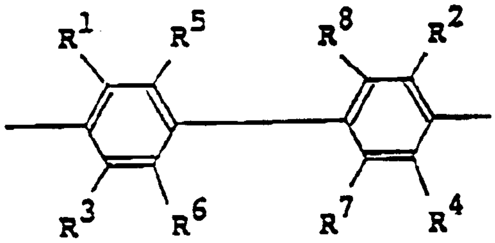

(I)

worin $R^1$ bis $R^8$ jeweils unabhängig voneinander ein Wasserstoffatom, eine niedere Alkylgruppe mit 1 bis 4 Kohlenstoffatomen oder ein Halogenatom sind,
(B) einen Härter, (C) einen Füllstoff und (D) ein Silankopplungsmittel mit mindestens einer Aminogruppe, wobei die oder jede Aminogruppe eine sekundäre Aminogruppe ist.

2. Halbleiter verkapselnde Epoxyharzzusammensetzung nach Anspruch 1, wobei der Härter (B) ein Phenol-Novolakharz ist.

3. Halbleiter verkapselnde Epoxyharzzusammensetzung nach Anspruch 1 oder 2, wobei der Füllstoff (C) verschmolzenes Siliciumdioxid umfaßt und die Menge des Füllstoffs (C) 73 bis 90 Gew.-% auf der Basis der gesamten Zusammensetzung beträgt.

4. Halbleiter verkapselnde Epoxyharzzusammensetzung nach Anspruch 3, wobei das verschmolzene Siliciumdioxid 40 bis 90 Gew.-% (C′) zerkleinertes verschmolzenes Siliciumdioxid mit einem durchschnittlichen Partikeldurchmesser von nicht mehr als 12 μm und 10 bis 60 Gew.-% (C″) kugelförmiges verschmolzenes Siliciumdioxid mit einem durchschnittlichen Partikeldurchmesser von nicht mehr als 40 μm umfaßt.

5. Halbleiter verkapselnde Epoxyharzzusammensetzung nach einem der vorstehenden Ansprüche, wobei das sekundäre Aminogruppen enthaltende Silankopplungsmittel (D) N-Phenyl-3-aminopropyltrimethoxysilan ist.

6. Halbleiter verkapselnde Epoxyharzzusammensetzung nach einem der vorstehenden Ansprüche, die außerdem (E) ein Blockcopolymer aus aromatischem Phenylkohlenwasserstoffkonjugiertem Dien umfaßt.

7. Halbleiter verkapselnde Epoxyharzzusammensetzung nach einem der vorstehenden Ansprüche, die außerdem (F) ein modifiziertes Siliconöl umfaßt.

8. Halbleiter verkapselnde Epoxyharzzusammensetzung nach einem der vorstehenden Ansprüche, die außerdem (G) eine organische Phosphinverbindung umfaßt.

## Revendications

1. Composition de résine époxyde d'encapsulation pour un semi-conducteur comprenant (A) une résine époxyde comprenant une résine époxyde de type biphényle ayant un composant de squelette représenté par la formule (I) suivante :

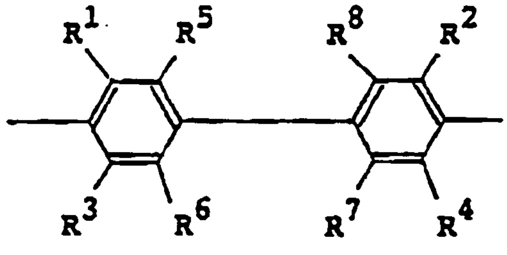

(I)

où $R^1$ à $R^8$ sont chacun, indépendamment les uns des autres, un atome d'hydrogène, un groupe

alkyde inférieur ayant 1 à 4 atomes de carbone ou un atome d'halogène,
(B) un agent de durcissement, (C) une charge et (D) un agent de pontage silane ayant au moins un groupe amino, le ou chaque groupe amino étant un groupe amino secondaire.

2. Composition de résine époxyde d'encapsulation pour un semi-conducteur, selon la revendication 1, où l'agent de durcissement (B) est une résine phénol-novolaque.

3. Composition de résine époxyde d'encapsulation pour un semi-conducteur selon la revendication 1 ou 2, où la charge (C) comprend de la silice fondue et la proportion de la charge (C) est de 73 à 90 % en poids relativement à la composition totale.

4. Composition de résine époxyde d'encapsulation pour un semi-conducteur selon la revendication 3, où la silice fondue comprend de 40 à 90 % en poids de (C′), de la silice fondue broyée ayant un diamètre moyen des particules ne dépassant pas 12 μm, et 10 à 60 % en poids de (C″), de la silice fondue sphérique ayant un diamètre moyen des particules ne dépassant pas 40 μm.

5. Composition de résine époxyde d'encapsulation pour un semi-conducteur selon l'une quelconque des revendications précédentes, où l'agent de pontage silane contenant un groupe amino secondaire (D) est le N-phényl-3-aminopropyltriméthoxysilane.

6. Composition de résine époxyde d'encapsulation pour un semi-conducteur selon l'une quelconque des revendications précédentes, qui comprend de plus (E) un copolymère séquencé d'hydrocarbure vinylique aromatique-diène conjugué.

7. Composition de résine époxyde d'encapsulation pour un semi-conducteur selon l'une quelconque des revendications précédentes, qui comprend de plus (F) une huile silicone modifiée.

8. Composition de résine époxyde d'encapsulation pour un semi-conducteur selon l'une quelconque des revendications précédentes, qui comprend de plus (G) une phosphine organique.